Europäisches Patentamt

European Patent Office

Office européen des brevets

(11) Publication number: **0 432 794 A1**

# EUROPEAN PATENT APPLICATION

(21) Application number: 90124203.2

(22) Date of filing: 14.12.90

(51) Int. Cl.5: **C04B 35/80**, C23C 14/06

(30) Priority: 14.12.89 JP 323819/89

(43) Date of publication of application:
**19.06.91 Bulletin 91/25**

(84) Designated Contracting States:
**DE FR GB NL**

(71) Applicant: MITSUBISHI MATERIALS
CORPORATION
6-1, Otemachi 1-chome
Chiyoda-ku Tokyo 100(JP)

(72) Inventor: Inukai, Takao
Oumiya Apt.3-407, 1-choume, 191
Kitafukuro-machi
Oumiya-shi, Saitama(JP)
Inventor: Tsukada, Kazuo, MMCC Apartment
101
2-Choume, 31-5, Amanuma, Suginami-ku
Tokyo(JP)
Inventor: Tachibana, Kan-Ichi
3-choume, 22-9, Musashidai, Hidaka-machi
Iruma-gun, Saitama(JP)

(74) Representative: Bühling, Gerhard, Dipl.-Chem.
et al
Patentanwaltsbüro Tiedtke-Bühling-Kinne
Grupe-Pellmann-Grams Bavariaring 4
W-8000 München 2(DE)

(54) **Silicon carbide composite structure in use for cooking in a microwave oven.**

(57) The present invention discloses a silicon carbide composite structure comprising silicon carbide matrix having a specific resistivity higher than $10^4$ ohm/cm, and ceramic fibers or whisker reinforcing said silicon carbide matrix. This composite structure is used for cooking in a microwave oven, which is self-heated by dielectric absorbing the microwave energy radiated in the microwave-oven, and radiates an infrared radiation to surface(s) to be burned or scorched, of matrial(s) to be cooked.

EP 0 432 794 A1

# SILICON CARBIDE COMPOSITE STRUCTURE IN USE FOR COOKING IN A MICROWAVE OVEN

## Field of the Invention

The present invention relates to a silicon carbide composite structure in use for cooking in a microwave oven, by being heated by dielectric heating through absorption of microwave energy. Particularly, it relates to the specific composite structure to absorb microwave energy for being heated in use for cooking in a microwave oven.

## Description of the Prior Art

Various kinds of materials, e.g. wooden ware, web, cloth, plastics and the like have been worked or dried by using microwave heating in which microwave energy is absorbed by the dielectric materials to be heated or dried. In this process, the dipoles in the material are vibrated by alternate electric field of the microwave so as to generate friction of the molecules thereby heating dielectrically the materials.

Such utilization of microwave heating is applied in a microwave oven to home cooking, in which water molecules having electric dipoles presented in the material to be heated or cooked are vibrated or serves as a source for heating so that the cooking involving water and the drying can be exerted.

In the conventional microwave oven, the heating by vibrating water molecules with absorption of the microwave energy can not enable to heat the materials at the temperature higher than 100 °C, and further, when all water is evaporated to be absent completely in the materials, there would be no source for heating the materials, and no raising of the temperature of the materials. Therefore, it is impossible to heat the materials at the temperature enough to be tanned or burned or scorched appropriately by using only radiation of microwave energy.

Accordingly, in a certain method of cooking by a microwave oven, the surface of the materials to be cooked should be burned or scorched before or after microwave oven cooking, by using an electric heater or gas heating. Further, a source material which can be heated by absorbing the microwave energy, to the enough high temperature, e.g. some species of dielectric materials or magnetic materials can be used so as to produce directly the burned or scorched surface of the material being cooked, by getting in touch with the heated source or placing the heated source near the surface of the material being cooked or to be cooked.

Such source material to be heated at the enough high temperature by absorbing the microwave energy should be heat-resistant ceramic materials which may be species of lead titanates, or ferrite species, or soda glass species. But, those materials are weak in resistance to thermal shock, and further, have problems in that cracks are easily generated by contacting with water drop(s) occurred when cooked in the microwave oven.

Such silicon carbide has a high resistance to thermal shock and can be self heated (exothermic) by absorbing a microwave energy at the enough high temperature, but it will generate an electric spark from the surface of the material absorbing the microwave energy, during radiation of microwave in a home microwave oven, because it's electric resistivity is relatively low, in a semiconducting state. If one wishes to increase the electric resistivity of the silicon carbide materials by sintering more with the addition of a sintering agent such as boron carbide and alumina, such sintering agent which is electrically impurities will serve to reduce the resistivity of the semiconducting silicon carbide.

The more addition of the sintering agent to the silicon carbide material would increase the compactness of the sintered material thereby increasing the electric resistivity, but in practice the sintering agent serves more as impurities to reduce the resistivity. Therefore, in practice, the silicon carbide materials having higher resistivity can not substantially be produced only by sintering more the silicon carbide material. Microwave energy will be concentrated so as to raise a surface potential enough to produce electric spark or discharge, especially when the silicon carbide material has lower resistivity. Therefore, an insulating coating with high heat resistance is necessary to be formed on a surface of the silicon carbide composite in use for self-heating source in a microwave oven.

Such self-heating material to be used in a microwave oven should be in a form of plate or dish or disc, but it is difficult to sinter silicon carbide material into such shapes without any sintering agents, and even if it is successful to sinter, the sintered ceramics will be very fragile, because such ceramics is monolithic.

Further, Warren's patent U.S. Patent No. 4,766,013 discloses a carbon-silicon composite article designed specifically for use in high temperature, corrosive and erosive environments such as those found in heat engines, heat exchangers stationary power equipments and industrial process equipments. The disclosed article comprises a multiplicity of carbon fibers forming a shaped article, a coating of pyrolytic carbon extending over each of said fibers, a chemical vapor deposition formed coating of silicon carbide extending over each of the pyrolytic carbon coated fibers, said pyrolytic carbon coating and said silicon coating having been applied to said fibers in a manner whereby said fibers are free to move relative to said coatings.

Summary of the Invention With the foregoing considerations in mind, the present invention contemplates the provision of the silicon carbide composite structure which can be self heated by radiation of microwave in a home microwave oven through dielectric absorption of the microwave energy, to a temperature higher than 100 °C.

It is an object of the present invention to provide a silicon carbide composite structure with enough high resistance against thermal shock, such that it cannot be cracked nor fractured even when any drops of water is in touch with the surface of the heated composite structure which is kept and irradiated by a microwave energy in a microwave oven.

It is another object of the present invention to provide a silicon carbide composite with enough high elective resistivity not to generate sparks from the surface thereof by radiation of microwave energy.

Detailed Description of Preferred Embodiments

In accordance with the present invention, the structure of the silicon carbide composite consists of silicon carbide matrix having a specific electric resistivity higher than $10^4$ ohm-cm, and a reinforcing ceramic fibers or whiskers.

The inventive composite can be formed in form of a thin plate, a dish or a bar or a net.

Further, the silicon carbide matrix can be appropriately produced or deposited from a vapor phase by a chemical vapor deposition.

A monolithic material of silicon carbide is inappropriate as a self-heating (exothermic) material in which heat is generated by absorption of the microwave energy, because it does not have sufficient strength to be used in practice in form of the above-mentioned various shapes. Accordingly, the inventive composite structure of silicon carbide uses reinforcing fibers or whiskers, made of ceramics such as alumina, silica, zirconia, silicon carbide, silicon nitride and carbon. The reinforcing structure can improve the strength of the silicon carbide material, and further the high resistance to thermal shock thereof. Further, the inventive composite structure can have less frequency of occurrence of sparks by radiation of microwave energy.

However, there is only some limited and specialized methods of producing the silicon carbide matrix having a specific electric resistivity higher than $10^4$ ohm-cm, which does not occur sparks nor electric discharge from the surface thereof. Among those methods, the difficulties resides in that the silicon carbide powder without any sintering agent cannot be easily sintered even at the high temperature owing to the intrinsic covalency of silicon carbide. The sintering agent will reduce the specific electric resistivity of the sintered silicon carbide material. The raise of the specific resistivity is very restricted in such conventional sintering method.

First of all, a conglomeration (set) of ceramic fibers or whiskers, which may be made of at least one species of material selected from the group consisting of alumina, silica, zirconia, silicon carbide, silicon nitride and carbon is produced by an appropriate method. Then, silicon carbide is deposited in, on and around the set of the fibers or whiskers by a chemical vapor deposition. When the ceramic fibers or whiskers is used to form the set, and the composite is produced in accordance with the present invention, the silicon carbide composite even with size of about 30 cm can be produced.

The silicon carbide material to be deposited on the set can be obtained to have high purity of the material by using di-methyl di-chloro silane, methyl tri-chloro silane, silane, methane or propane as a source of Si and/or C. Di-methyl di-chloro silane, and methyl tri-chloro silane and silane can be used as a pure source of both of silicon and carbon. Further, methane and propane can be used as a pure source of carbon.

Then, the purer material can provide higher specific resistivity, so that it could have the specific resistivity as high as $10^4$ ohm-cm. Further, even if an impurity is added to the material in an amount as low as so to modify the properties of the composite, the composite with dielectric self-heating performance and the specific resistivity enough to avoid sparks from the surface of the composite can be produced.

The silicon carbide composite produced by the chemical vapor deposition has higher resistance to thermal shock, and then, can have $\Delta$ T (thermal shock resistance) of greater than 400 °C. Such composite structure is not cracked by contacting with water drops occurred when the material is cooked at high temperature in a microwave oven or cooled.

The method for producing the inventive composite structure is one of the chemical vapor deposition, and the requirements thereof are as follows.
A gas of methyl trichlorosilane and the analog silane as a source of Si and C flows in an atmosphere for treating the set of ceramic fibers or whiskers maintained at the temperature of about 1000 °C, so as to deposit SiC matrix to and on the set of ceramic fibers or whiskers by a chemical vapor deposition.

Further, the inventive composite structure can be produced by immersing organic silicon compound such as polycarbosilane which can be decomposed into SiC by thermal decomposition, into the structure of ceramic fibers or whisker and then treating by a hot-press process under determined pressure and temperature.

Therefore, the inventive composite structure is a combination of the structure of ceramic fibers or whisker, and silicon carbide matrix. Then, a plate or dish having the thickness lower than 2 mm can be easily produced. Further, because the composite structure is reinforced with ceramic fibers or whiskers, it is hardly cracked, and is not fragile nor brittle.

The inventive composite structure is usable as a self-heating material to be used in a microwave oven for generating a burn or a scorch streak or trace on the surface(s) of the material to be cooked or cooked.

The present invention is further illustrated by the following example to show manufacture of the inventive composite structure, but, which should not be interpreted for the limitation of the invention.

EXAMPLE 1

A web ( 3 cm diameter, 0.2 cm thick) of silicon carbide fibers was impregnated with polycarbosilane, and heated under pressure to exert hot pressing, producing a fiber-reinforced silicon carbide disc having a specific electric resistivity of 2 x $10^4$ ohm/cm.

The resulting disc was put in a home microwave oven with output of 500 W, and microwave was applied for about one minute, then, the temperature of the surface of the disc was 250 °C. Next, the meat got in contact with the heated disc, and was exposed to the microwave radiation for two minutes. It was found that the meat has surface scorched or burned, and was appropriately cooked even at the middle thereof.

Even when drops of water or juice were in contact with the heated disc during cooking and after cooking, no crack nor fracture was found in the disc.

Further, there was no spark discharge during application of microwave in the oven.

EXAMPLE 2

Alumina fibers were set and pressed so as to produce a felt pad of 18 cm in diameter, 3 cm in height and 0.15 cm in thickness in a dish shape. The pad was impregnated with silicon carbide by chemical vapor deposition, producing an alumina fiber reinforced silicon carbide heating pad with a specific electric resistivity of $10^9$ ohm/cm.

This pad was put in a home microwave oven having output power of 500 W, and the microwave radiation was applied for two minutes, and then, the temperature of the surface of the pad was found at about 300 °C.

Then, the heated pad was in touch with a fish to be cooked, and the microwave radiation was applied for four minutes, and then, the surface of the fish, being in touch with the pad was found burn or brown to an appropriate extent. Then, the fish was turn back, and then, further microwave radiation was applied for two minutes. The fish was found suitably cooked, and the both surfaces of the fish were burned and cooked.

There was not found discharge from the heating pad, and cracking generated by scattered water getting in touch with the pad.

EXAMPLE 3

Carbon fibers were settled and pressed so as to produce a carbon fiber plate of 13 cm x 8 cm x 0.1 cm. The plate was impregnated with silicon carbide by chemical vapor deposition, producing a carbon fiber reinforced silicon carbide heating plate with a specific electric resistance of $10^7$ ohm/cm.

This plate was put in a home radar (microwave) range having power of 600 W, and the microwave radiation was applied for three minutes, and then, the temperature of the surface of the plate was found at about 500 °C.

Then, the heated plate was placed at the position in the distance of about 3 cm above and from the surface of gratin to be cooked, and the microwave radiation was applied for six minutes, and then, the surface of the gratin below the plate was found burn or brown to an appropriate extent, cooked appropriately.

There was not found any sparks nor electric discharge from the surface of the heating plate, and further, no cracks was generated by scattered drops of water on the surface of the heated plate.

REFERENCE EXAMPLE 1

Alumina fibers were set and pressed so as to produce a plate of 15 cm x 15 cm x 0.2 cm (in thickness) made of alumina fibers. The plate was impregnated with silicon carbide containing impurities by chemical vapor deposition, producing an alumina fiber reinforced silicon carbide self-heating plate with a specific electric resistivity of $10^3$ ohm-cm. The resulting plate was put in a home microwave oven having power of 500 W, and the microwave radiation was applied, and then, the sparks or discharge were found within 15 seconds from the beginning of the radiation.

REFERENCE EXAMPLE 2

Silicon carbide with alumina sintering agent was fired to be sintered so as to produce a silicon carbide self-heating plate with a specific electric resistivity of 1 ohm-cm. Then, the microwave radiation was applied to the silicon carbide plate and then, the sparks or discharge was found within 20 seconds from the beginning of the radiation.

REFERENCE EXAMPLE 3

A ferrite sintered plate of 20 cm x 20 cm x 1 cm in size was used to be heated by the application of microwave radiation so as to cook a meat in the similar way of Example 1. The meat cooked was found burn streak. However, cracks were produced when water drop(s) was scattered on the heated surface of the ferrite plate after cooked, and and could not be used again.

As described in the foregoings, the inventive composite structure will enable use of less expensive self-heating material with high resistance to thermal shock, and enough strength and toughness to be used as a pyrometic material used in a home microwave oven. Further, the inventive composite structure with superior figure of merit can be more easily manufactured.

The invention may be practiced or embodied in still other ways without departing from the spirit or essential character thereof. The preferred embodiments described herein are illustrative and not restrictive, the scope of the invention being indicated by the appended claims and all variations which come within the meaning of the claims are intended to be embraced therein.

The present invention discloses a silicon carbide composite structure comprising silicon carbide matrix having a specific resistivity higher than $10^4$ ohm/cm, and ceramic fibers or whisker reinforcing said silicon carbide matrix. This composite structure is used for cooking in a microwave oven, which is self-heated by dielectric absorbing the microwave energy radiated in the microwave-oven, and radiates an infrared radiation to surface(s) to be burned or scorched , of matrial(s) to be cooked.

**Claims**

1. A silicon carbide composite structure in use for cooking in a microwave oven, which is self-heated by dielectric absorbing the microwave energy radiated in the microwave oven, and radiates an infrared radiation to surface(s) to be burned or scorched, of material(s) to be cooked;

    *comprising:*
    silicon carbide matrix having a specific re-sistivity higher than $10^4$ ohm-cm, and
    ceramic fibers or whisker reinforcing said silicon carbide matrix.

2. The composite structure as claimed in claim 1, wherein said composite structure is in form of the shape selected from the group consisting of plate, dish, disc, bar and net.

3. The composite structure as claimed in claim 1 or 2, wherein said silicon carbide matrix is formed by deposition of silicon carbide from a vapor phase by chemical vapor deposition, on, inside and around of a set made of the reinforcing ceramic fibers or whiskers.

4. The composite structure as claimed in either one of claims 1 to 3,
    wherein said reinforcing fibers or whiskers is selected from the group consisting of silicon carbide fibers, silicon nitride fibers, alumina fibers, carbon fibers, silica fibers, silica-alumina fibers, zirconia fibers, silicon carbide whiskers, zirconia whiskers, alumina whiskers, and silicon nitride whiskers.

5. a method of cooking a material in a microwave oven with a radiation of microwave energy, and/or forming a burned surface or scorched surface of the material, by using the ceramic composite structure as claimed in either one of claims 1 to 4, heating the ceramic composite structure by absorption of the microwave energy, and irradiating the radiation from said heated structure to the surface to be burned or scorched, of the material to be cooked,

## DOCUMENTS CONSIDERED TO BE RELEVANT

EP 90124203.2

| Category | Citation of document with indication, where appropriate, of relevant passages | Relevant to claim | CLASSIFICATION OF THE APPLICATION (Int. Cl. 5) |
|---|---|---|---|
| A | US - A - 3 671 275<br>(GATES et al.)<br>* Claims *<br>-- | 1,4,5 | C 04 B 35/80<br>C 23 C 14/06 |
| A | DE - A - 2 236 774<br>(MORGAN REFRATORIES)<br>* Examples; claim 1 *<br>-- | 1,4 | |
| A | DE - A - 2 357 217<br>(GENERAL ELECTRIC)<br>* Claim 1 *<br>---- | 1,4 | |

TECHNICAL FIELDS
SEARCHED (Int. Cl.5)

C 04 B
C 23 C

The present search report has been drawn up for all claims

| Place of search | Date of completion of the search | Examiner |
|---|---|---|
| VIENNA | 22-02-1991 | WILFLINGER |